# EUROPEAN PATENT APPLICATION

(11) **EP 2 214 249 A1**
(43) Date of publication of application: **04.08.2010**
(21) Application number: 08845683.5
(22) Date of filing: 15.10.2008
(51) Int. Cl.: H01M 14/00, H01L 31/04, H01M 2/22

(54) **DYE-SENSITIZED PHOTOELECTRIC CONVERSION DEVICE MODULE, METHOD FOR MANUFACTURING THE SAME, AND ELECTRONIC DEVICE**

(30) Priority: 30.10.2007 JP 2007281670
(71) Applicant: Sony Corporation, Tokyo 108-0075 (JP)
(72) Inventor: MOROOKA, Masahiro, Tokyo 108-0075 (JP); SUZUKI, Yusuke, Tokyo 108-0075 (JP); YONEYA, Reiko, Tokyo 108-0075 (JP)
(74) Representative: Müller - Hoffmann & Partner
(86) International application number: PCT/JP2008/068614
(87) International publication number: WO 2009/057445

(57) **Abstract**

A dye-sensitized semiconductor layer 3, a porous insulating layer 4 and a counter electrode 5 are laminated in order on a transparent conductive layer 2 formed on a transparent substrate 1, thereby structuring a dye-sensitized photoelectric conversion element. The counter electrode 5 is formed from a foil made of either a metal or an alloy having a catalyst layer on a side of one surface of the porous insulating layer 4, or from a foil made of a material having a catalytic ability. The transparent conductive layer 2 of one dye-sensitized photoelectric conversion element, and the counter electrode 5 of the other dye-sensitized photoelectric conversion element are electrically connected to each other in a portion between the two dye-sensitized photoelectric conversion elements adjacent to each other. The dye-sensitized semiconductor layer 3 and the porous insulating layer 4 are impregnated with an electrolyte. Each of the dye-sensitized photoelectric conversion elements is covered with a sealing layer 7.

## Description

### Technical Field

The present invention relates to a dye-sensitized photoelectric conversion element module and a method of manufacturing the same, and an electronic apparatus, and, for example, is suitable for being applied to a dye-sensitized solar cell module using a dye-sensitized semiconductor layer made of semiconductor fine particles supporting a dye, and various kinds of electronic apparatuses.

### Background Art

It is said that when fossil fuel such as coal or oil is used as an energy source, the global warning is caused because carbon dioxide is generated due to use of the fossil fuel. In addition, use of a nuclear energy is fraught with a risk of contamination due to nuclear radiation. At present when many people talk about the environmental concerns, dependency on these energies is fraught with problems.
On the other hand, the solar cell as a photoelectric conversion element for converting a solar light into an electrical energy exerts an extremely less influence on the global environment because it uses the solar light as the energy source, and thus is expected to be further widely used.

Although various materials are known as a material for the solar cell, a lot of solar cells each using silicon is offered commercially. These solar cells are roughly classified into a crystalline silicon system solar cell using single-crystalline or polycrystalline silicon, and an amorphous silicon system solar cell. Heretofore, single-crystalline or polycrystalline silicon, that is, crystalline silicon has been used in the solar cells in many cases.
However, although a photoelectric conversion efficiency representing a performance for converting a light (solar) energy into an electrical energy is higher in the crystalline silicon system solar cell than in the amorphous silicon system solar cell, the productivity was low in the crystalline silicon system solar cell because it took a lot of energy and time to glow a crystal, and thus the crystalline silicon system solar cell was disadvantageous in a cost phase.

In addition, the amorphous silicon system solar cell has the features that a light adsorbing property is high, a selection range of a substrate is wide, promotion for increasing an area is easily attained as compared with the crystalline silicon system solar cell. However, the photoelectric conversion efficiency is lower in the amorphous silicon system solar cell than in the crystalline silicon system solar cell. Moreover, although the amorphous silicon system solar cell has the higher productivity than that of the crystalline silicon system solar cell, the amorphous silicon system solar cell requires a vacuum process for manufacture similarly to the case of the crystalline silicon system solar cell, and thus still has a large burden in an equipment phase.

On the other hand, for the lower cost of the solar cells, many solar cells using organic materials instead of using the silicon system materials have been searched. However, the photoelectric conversion efficiency of such a solar cell is so very low as to be equal to or smaller than 1%, and involves a problem about a durability as well.
Under such circumstances, an inexpensive solar cell using semiconductor fine particles sensitized by a dye is reported (refer to a Non-Patent Document 1). This solar cell is a wet solar cell which has a titanium oxide porous thin film spectroscopically sensitized by using a ruthenium complex as a sensitizing dye as a photo-electrode, that is, an electrochemical solar cell. The advantages of this dye-sensitized solar cell are such that an inexpensive titanium oxide can be used, light absorption of the sensitizing dye is over a wide visible light wavelength range up to 800 nm, and a high energy conversion efficiency can be realized because a quantum efficiency in photoelectric conversion is high. In addition, since the vacuum system is unnecessary in manufacture, the large-scaled equipment is not required.

In recent years, the action for developing a dye-sensitized solar cell module has been activated. A Z type structure is known as a structure of the dye-sensitized solar cell module. The dye-sensitized solar cell module having the Z type structure is such that a plurality of dye-sensitized solar cells are formed between two sheets of substrates, and are connected electrically in series with one another within the inside of the substrates. Also, it is known that the dye-sensitized solar cell module has a high efficiency of generation of electric power.
Non-Patent Document 1: Nature, 353, p. 737-740, 1991

### Disclosure of Invention

However, the dye-sensitized solar cell module having the Z type structure was unsuitable for thinning and weight saving because it was necessary to use the two sheets of substrates. A dye-sensitized solar cell module having a monolithic structure which can be manufactured with one sheet of substrate is known. However, the dye-sensitized solar cell module having the monolithic structure has a demerit of being inferior to the dye-sensitized solar cell module having the Z type structure in a phase of the characteristics because there are a lot of limits to a material for a counter electrode, and also it is impossible to prevent dye adsorption to the counter electrode in terms of the structure.

In the light of the foregoing, a problem to be solved by the present invention is to provide a dye-sensitized photoelectric conversion element module such as a dye-sensitized solar cell in which only one sheet of substrate is required to be used, a counter electrode can be structured in a thin form, thereby making thinning and weight saving possible, and there is no restriction in a phase of a material for the counter electrode, and also which has the same performance of generation of electric power that of the dye-sensitized solar cell module having the Z type structure and a method of manufacturing the same, and an electronic apparatus using the excellent dye-sensitized photoelectric conversion element module described above.

In order to solve the problem described above, according to the first invention, there is provided a dye-sensitized photoelectric conversion element module having a plurality of dye-sensitized photoelectric conversion elements electrically connected in series with one another, the dye-sensitized photoelectric conversion element module being **characterized in that**:
a plurality of areas on a transparent substrate have transparent conductive layers, respectively;
a dye-sensitized semiconductor layer, a porous insulating layer and a counter electrode are laminated in order on the transparent conductive layer, thereby structuring the dye-sensitized photoelectric conversion element;
the counter electrode is formed from a foil made of either a metal or an alloy having a catalyst layer on one surface, of the porous insulating layer, or a foil made of a material having a catalytic ability;
the transparent conductive layer of one dye-sensitized photoelectric conversion element, and the counter electrode of the other dye-sensitized photoelectric conversion element are electrically connected to each other in a portion between the two dye-sensitized photoelectric conversion elements adjacent to each other;
at least the dye-sensitized semiconductor layer and the porous insulating layer are impregnated with an electrolyte; and
each of the dye-sensitized photoelectric conversion elements is covered with a sealing layer.

The foil, made of either the metal or the alloy, forming the counter electrode preferably uses a foil made of either a metal or an alloy containing therein at least one or more kinds of elements selected from the group consisting of Ti, Ni, Cr, Fe, Nb, Ta, W, Co and Zr. The catalyst layer provided on the one surface, on the porous insulating layer side, of the foil made of either the metal or the alloy or the material having the catalytic ability preferably contains therein at least one or more kinds of elements selected from the group consisting of Pt, Ru, Ir and C. A thickness of the counter electrode, that is, a total of thicknesses of the foil made of either the metal or the alloy, and the catalyst layer, or a thickness of the foil made of the material having the catalytic ability is preferably equal to or smaller than 0.1 mm from a viewpoint of the thinning of the dye-sensitized photoelectric conversion element module. For supporting the catalyst layer on the foil made of either the metal on the alloy, it is possible to use a method of wet-coating a solution containing therein a catalyst or a precursor of the catalyst, or a dry type method such as a sputtering method, a vacuum evaporation method or a chemical vapor deposition (CVD) method.

The counter electrode and the transparent conductive layer may be directly joined to each other, or may be joined to each other through a conductive material. In the latter case, specifically, the counter electrode and the transparent conductive layer, for example, is joined to each other through a conductive adhesive agent, or a low-melting point metal having a melting point of 300°C or less, or an alloy. A commercially available silver, carbon, nickel or copper paste, or the like can be used as the conductive adhesive agent, and in addition thereto, an anisotropically conductive adhesive agent or a film-shaped agent can also be used. In addition, various kinds of low-melting point metals or alloys such as In and an In-Sn system solder capable of being joined to the transparent conductive layer can also be used. Moreover, when a joining portion between the counter electrode and the transparent conductive layer directly contact the electrolyte, the joining portion may be protected with the resin or the like, thereby preventing the joining portion from directly contacting the electrolyte.

Although a material for the sealing layer is not especially limited, it is preferable to use an electrically insulating material which has a high gas barrier property, and which is chemically inactive. Specifically, it is possible to use a resin, various kinds of adhesive agents, a glass frit or the like. More specifically, it is possible to use various kinds of ultraviolet (UV) curable resins such as an epoxy resin, an urethane resin, a silicone resin, and an acrylic resin, various kinds of thermosetting resins, a hot-melt resin, a low-melting-point glass frit, or the like.

An armoring material is preferably provided on the sealing layer. A material having a high gas barrier property is suitably used as the armoring material. Specifically, for example, the material having a high gas barrier property which is equal to or smaller than 100 (cc/m²/day/atm) in permeation rate of oxygen, and is equal to or smaller than 100 (g/m²/day) in permeation rate of water vapor is used as the armoring material. A film having a gas barrier property typified by an armoring film for foods, for example, is used as the armoring material. Suitably, a film, having a gas barrier property, which is obtained by laminating at least one or more kinds of materials, each having a gas barrier property, selected from the group consisting of aluminum, silica and alumina, or the like is used as the armoring material. The armoring material is suitably provided integrally with the sealing layer so as to cover the outermost periphery of the sealing layer, and is sealed under a reduced pressure and in an inactive gas atmosphere. Such an armoring material is provided on the sealing layer, which results in that gas such as oxygen, or water vapor can be prevented from penetrating from the outside into the inside of the dye-sensitized photoelectric conversion element module. Therefore, it is possible to suppress deterioration of the characteristics of the photoelectric conversion efficiency or the like, and it is possible to improve the durability of the dye-sensitized photoelectric conversion element module.

The transparent conductive layer formed in a plurality of areas on the transparent substrate may be patterned before the dye-sensitized semiconductor layer, the porous insulating layer, and the counter electrode are laminated, or may be patterned after the dye-sensitized semiconductor layer, the porous insulating layer, and the counter electrode are laminated. This patterning can be carried out by utilizing the various kinds of etching methods conventionally known, laser scribe, physical polishing processing, or the like.

A surface resistance (sheet resistance) of the transparent conductive layer formed on the transparent substrate is preferable as the surface resistance thereof is set as being lower. Specifically, the surface resistance of the transparent conductive layer is preferably equal to or lower than 500 Ω/□, and is more preferably equal to or lower than 100 Ω/□. The known material can be used as a material for the transparent conductive layer. Specifically, although there are given an indium-tin composite oxide (ITO), fluorine-doped SnO₂ (FTO), antimony-doped SnO₂ (ATO), SnO₂, ZnO, indium-zinc composite oxide (IZO), or the like, the present invention is by no means limited thereto. Also, a material obtained by combining two or more kinds of materials described above with one another can also be used. In addition, for the purpose of enhancing a power collection efficiency by reducing the surface resistance of the transparent conductive substrate having the transparent conductive layer formed on the transparent substrate, a wiring made of a conductive material such as a metal or carbon having a high conductivity may be specially provided. Although there is especially no limit to the conductive material used in the wiring, the conductive material desirably has a high corrosion resistance, a high oxidation resistance, and a low leakage current of the conductive material itself.

A material for the transparent substrate is not especially limited, and thus various kinds of materials can be used as long as each of them is transparent. A material which is excellent in barrier property against the moisture or the gas which penetrates from the outside of the dye-sensitized photoelectric conversion element, solvent resistance, weathering resistance, and the like is preferable as the material for the transparent substrate. Specifically, there are given a transparent inorganic substrate made of a quartz, a sapphire, a glass or the like, and a transparent plastic substrate made of polyethylene terephthalate, polyethylene naphthalate, polycarbonate, polystyrene, polyethylene, polypropylene, polyphenylene sulfide, polyvinylidene fluoride, tetraacetylcellulose, brominated phenoxy, an aramid class, a polyimide class, a polystyrene class, a polyarylate class, a polysulfone class, a polyolefin class, or the like. Although of them, the substrate having a high transmittance in a visible light range is especially, preferably used, the present invention by no means limited thereto. When the workability, the light weight property and the like are taken into consideration, the transparent plastic substrate is preferably used as the transparent substrate. In addition, a thickness of the transparent substrate is not especially limited, and thus can be freely selected depending on the transmittance of the light, the barrier property between the inside and the outside of the dye-sensitized photoelectric conversion element, and the like.

The dye-sensitized semiconductor layer is typically a porous semiconductor layer made of semiconductor fine particles supporting a dye. In addition to an elemental semiconductor typified by silicon, various kinds of compound semiconductors, a compound having a perovskite structure, or the like can be used as the material for the semiconductor fine particle. Each of these semiconductors is preferably an n-type semiconductor in which the electrons in a conduction band become the carriers under photo-excitation to give an anode current. Concretely exemplifying, these semiconductors are TiO₂, ZnO, WO₃, Nb₂O₅, TiSrO₃, SnO₂, and the like. Of them, anatase-type TiO₂ is especially preferable. The kind of semiconductor is by no means limited thereto, and thus a semiconductor material obtained by mixing two or more kinds of semiconductors described above can also be used. Moreover, the semiconductor fine particle can take various kinds of forms such as a particle-shaped form, a tube-shaped form, and a rod-shaped form as may be necessary.

Although there is especially no limit to a particle diameter of the semiconductor fine particle, the particle diameter of the semiconductor fine particle is preferably in the range of 1 to 200 nm in average particle diameter of the original particle, and is especially preferably in the range of 5 to 100 nm in average particle diameter of the original particle. In addition, it is possible that the semiconductor fine particles each having that average particle diameter are mixed with the semiconductor fine particles each having an average particle diameter larger than that average particle diameter, and an incident light is scattered by the semiconductor fine particles each having the larger average particle diameter, thereby enhancing a quantum yield. In this case, the average particle diameter of the semiconductor fine particles mixed separately is preferably in the range of 20 to 500 nm.

Although there is especially no limit to a method of manufacturing the semiconductor layer made of the semiconductor fine particles, a wet film forming method is preferable when the physicality, the convenience, the manufacture cost, and the like are taken into consideration. A method is preferable in which a paste obtained by uniformly dispersing powders or a sol of semiconductor fine particles into a solvent such as water or an organic solvent is prepared and is then applied onto a transparent conductive substrate. There is especially no limit to a method for the application, and thus the application can be carried out in accordance with the known method. For example, the application can be carried out in accordance with a dip method, a spray method, a wire-bar method, a spin coat method, a roller coat method, a blade coat method, or a gravure coat method. In addition, the application can also be carried out in accordance with a wet printing method. Here, the wet printing method is typified by various kinds of methods such as anastatic printing, offset, gravure, copper plate printing, rubber plate printing, and screen printing. When a crystalline titanium oxide is used as the material for the semiconductor fine particle, a crystal type thereof is preferable an anatase type from a viewpoint of photocatalytic activity. The anatase type titanium oxide may be commercially available powder, sol or slurry. Or, the anatase type titanium oxide having a predetermined particle diameter may also be made by utilizing a known method of, for example, hydrolyzing a titanium oxide alkoxide. When the commercially available powder is used, the secondary aggregation of the powder is preferably resolved. Also, in a phase of preparation of the application liquid, the particles are preferably dispersed by using a mortar, a ball mill, a ultrasonic dispersion device or the like. At this time, in order to prevent the particles resolved from the secondary aggregation from aggregating again, it is possible to add acetylacetone, a hydrochloric acid, a nitric acid, a surface active agent, a chelate agent or the like. In addition, for thickening, it is possible to add various kinds of thickening agents such as a polymer molecule such as polyethylene oxide or polyvinyl alcohol, and a cellulose system thickening agent.

The semiconductor layer made of the semiconductor fine particles, in other words, the semiconductor fine particle layer is preferably large in surface area thereof so as to be able to adsorb many sensitizing dyes. For this reason, a surface area in a state of applying the semiconductor fine particle layer onto a supporting body is preferably 10 or more times as large as that of a projected area, and is more preferably 100 or more times as large as that of the projected area. Although there is especially no limit to an upper limit of this, the surface area is normally about 100 times as large as that of the projected area. In general, a rate of capturing a light becomes high because an amount of dyes supported per unit projected area increases as a thickness of this further increases. However, a loss due to a recombination of the electric charges also increases because a diffusion distance of each of the injected electrons increases. Therefore, although a preferred thickness exists in the semiconductor fine particle layer, the preferred thickness is generally in the range of 1 to 100 µm, is more preferably in the range of 1 to 50 µm, and is especially, preferably in the range of 3 to 30 µm. It is preferable that the particles are made to electronically contact each other after the semiconductor fine particle layer is applied onto a supporting body, and are burnt for the purpose of enhancing a film strength, and enhancing adhesive to the substrate. Although there is especially no limit to the range of a burning temperature, the burning temperature is normally in the range of 40 to 700°C, and is more preferably in the range of 40 to 650°C because when the burning temperature is made to rise too much, a resistance of the substrate increases, and the substrate may be melt. In addition, although there is especially no limit to a burning time, the burning time is normally in the range of about ten minutes to about ten hours. After burning, for the purpose of increasing a surface area of the semiconductor fine particle layer, and enhancing necking between the semiconductor fine particles, for example, there may be carried out chemical plating using a titanium tetrachloride solution, a necking treatment using a titanium trichloride solution, a dip treatment for the semiconductor fine particle sol having a diameter of 10 µm or less, or the like. When a plastic substrate is used as the supporting body of the transparent conductive substrate, it is also possible that a paste containing therein a binder is applied onto the substrate, and is then pressure-bonded to the substrate by carrying out press hot.

The dye supported by the semiconductor layer is not especially limited as long as it exhibits a sensitizing operation. For example, there is given a xanthene system dye such as Rhodamine B, rose bengal, eosine or erythrosine, a cyanine system dye such as merocyanine, quinocyanine or cryptocyanine, a basic dye such as phenosafranine, Cabri Blue, thiocin or Methylene Blue, or a porphyrin system compound such as chlorophyll, zinc porphyrin, or magnesium porphyrin. With regard to other dyes, there are given an azo dye, a phthalocyanine compound, a coumarin system compound, an Ru bipyridine complex compound, an Ru terpyridine complex compound, an anthraquinone system dye, a polycyclic quinone system dye, squalirium, and the like. Of them, the Ru bipyridine complex compound is especially preferable because a quantum yield thereof is high. However, the sensitizing dye is by no means limited thereto, and thus two or more kinds of sensitizing dyes described above may be mixed with one another.

A method of adsorbing the dye to the semiconductor layer is not especially limited. However, the sensitizing dyes described above can be dissolved in a solvent such as an alcohol class, a nitrile class, nitromethane, hydrocarbon halide, an ether class, dimethyl sulfoxide, an amide class, N-methylpyrrolidone, 1, 3-dimethylimidazolidinone, 3-methyloxazolidinone, an ester class, a carbonate class, a ketone class, hydrocarbon, and water. Also, the semiconductor layer can be immersed in the solvent described above, or the dye solution can be applied onto the semiconductor layer. In addition, when the dye having a high acidity, a deoxycholic acid or the like may be added for the purpose of reducing association between the dye molecules.
After the sensitizing dye is adsorbed, a surface of the semiconductor electrode may be processed by using an amine class for the purpose of promoting the removal of the excessively adsorbed sensitizing dye. Pyridine, 4-tert-butylpyridine, polyvinylpyridine or the like is given as an example of the amine class. When such a amine class is a liquid, it may be used as it is, or may be dissolved in an organic solvent to be used.

A material for the porous insulating layer is not especially limited so long as it has no conductivity. In particular, an oxide containing therein at least one or more kinds of elements selected from the group consisting of Zr, Al, Ti, Si, Zn, W and Nb, especially, zirconia, alumina, titania, silica or the like is desirably used. Typically, a fine particle of this oxide is used. A porosity of the porous insulating layer is preferably equal or larger than 10%. Although there is no limit to an upper limit of the porosity, the porosity is normally, preferably in the range of about 10 to about 80% from a viewpoint of the physical strength of the porous insulating layer. The porosity is equal to or smaller than 10%, which exerts an influence on the diffusion of the electrolyte, thereby remarkably reducing the characteristics of the dye-sensitized photoelectric conversion element module. In addition, a micropore diameter of the porous insulating layer is preferably in the range of 1 to 1000 nm. The micropore diameter is smaller than 1 nm, which exerts an influence on the diffusion of the electrolyte, and the impregnation of the dye, thereby reducing the characteristics of the dye-sensitized photoelectric conversion element module. Moreover, when the micropore diameter is larger than 1000 nm, there is caused the possibility that short-circuit is caused because the catalytic particles of the counter electrode invades into the porous insulating layer. Although there is no limit to a method of manufacturing the porous insulating layer, the porous insulating layer is preferably a sintered body of the oxide particles described above.

In addition to a combination of iodine (I₂) and a metal iodide or an organic iodide, or a combination of bromine (Br₂), and a metal bromide or an organic bromide, a metal complex such as a ferrocyanic acid chloride/ferricyanic acid chloride, or ferrocene/ferricinium ion, a sulfur compound such as sodium polysulfide, or alkyl thiol/alkyl disulfide, or a viologen dye, hydroquinone/quinone, or the like can be used as the electrolyte. Li, Na, K, Mg, Ca, Cs or the like is preferable as a cation of the metal compound described above, and a quaternary ammonium compound such as a tetraalkyl ammonium class, a pyridinium class or an imidazolium class is preferable as a cation of the organic compound described above. However, the present invention is by no means limited thereto. In addition, a material obtained by mixing two or more kinds of materials described above can also be used. Of them, the electrolyte obtained by combining I₂, and LiI, NaI or the quaternary ammonium compound such as imidazoliumiodide with each other is preferable. A concentration of an electrolyte salt is preferably in the range of 0.05 to 5 M for a solvent, and is more preferably in the range of 0.2 to 3 M for the solvent. A concentration of I₂ or Br₂ is preferably in the range of 0.0005 to 1 M, and is more preferably in the range of 0.001 to 0.3 M. In addition, an additive made of an amine system compound typified by 4-tert-butylpyridine may be added for the purpose of enhancing an open voltage.

Water, an alcohol class, an ether class, an ester class, a carbonate class, a lactone class, a carboxylate class, a triester phosphate class, a heterocyclic compound class, a nitryl class, a ketone class, an amide class, nitromethane, hydrocarbon halide, dimethyl sulfoxide, sulfolane, N-methylpyrrolidone, 1,3-dimethyl imdazolidinone, 3-methyloxazolidinone, hydrocarbon, or the like is given as the solvent composing the electrolyte composition described above. However, the present invention is by no means limited thereto, and thus a material obtained by mixing two or more kinds of materials described above can also be used. Moreover, an ion liquid of a tetraalkyl system, a pyridinium system, or an imidazolium system quaternary ammonium salt can also be used as the solvent.

For the purpose of reducing liquid leakage of the dye-sensitized photoelectric conversion element, and volatilization of the electrolyte, a gelatinizing agent, polymer, cross-linked monomer, or the like can be dissolved in the electrolyte composition described above, and in addition thereto, inorganic ceramic particles can be dispersed into the electrolyte composition. Thus, the resulting material can also be used as a gel-like electrolyte. With regard to a ratio between a gel matrix and the electrolyte composition, when an amount of electrolyte composition is much, an ion conductivity increases, but a mechanical strength decreased. Conversely, when the amount of electrolyte composition is too less, the mechanical strength is large, but the ion conductivity decreases. Therefore, the electrolyte composition is desirably in the range of 50 to 99 wt% of the gel-like electrolyte, and is more preferably in the range of 80 to 97 wt%. In addition, the electrolyte described above and a plasticizer are both dissolved in polymer, and the plasticizer is volatilized to be removed, thereby making it also possible to realize a total solid type dye-sensitized photoelectric conversion element module.

A method of manufacturing the dye-sensitized photoelectric conversion element module is not especially limited. However, when the thicknesses of the each layers, the productivity, the pattern precision, and the like are taken into consideration, the semiconductor layer, the porous insulating layer, the catalyst layer of the counter electrode, and the sealing layer before the dye is adsorbed are all preferably formed by utilizing the wet application method such as the screen printing or the spray application, and are especially, preferably all formed by utilizing the screen printing. The semiconductor layer and the porous insulating layer before the dye is adsorbed are preferably formed by the application and burning of the paste containing therein the particles composing the respective layers. The porosities of the respective layers are determined depending on a ratio between the binder component and the particles of the paste. The catalyst layer on the foil made of either the metal or the alloy is directed toward the porous insulating layer side, and the counter electrode is joined to the transparent conductive layer of the adjacent dye-sensitized photoelectric conversion element. Although the adsorbing of the dye to the semiconductor layer is preferably carried out before the counter electrode is joined to the transparent conductive layer, it may be carried out after the counter electrode is joined to the transparent conductive layer. After the joining of the counter electrode, the entire dye-sensitized photoelectric conversion element is fixed so as to be covered with the sealing layer. At this time, a liquid injection hole for introduction of the electrolyte is preferably left. After the electrolyte is enclosed into the inside of the sealing layer through the liquid injection hole, the liquid injection hole is preferably covered with the armoring material, and the sealing is preferably carried out under the reduced pressure or in the inert atmosphere.

The dye-sensitized photoelectric conversion element module can be manufactured into various shapes depending on applications thereof, and thus the shape thereof is not especially limited.
The dye-sensitized photoelectric conversion element module is most typically structured as the dye-sensitized solar cell module. However, the dye-sensitized photoelectric conversion element module may also be structured as any other suitable one other than the dye-sensitized solar cell module, for example, as a dye-sensitized photosensor or the like.

According to the second invention, there is provided a method of manufacturing a dye-sensitized photoelectric conversion element module having a plurality of dye-sensitized photoelectric conversion elements electrically connected in series with one another, the manufacturing method being characterized by having: the process for structuring the dye-sensitized photoelectric conversion element by laminating a transparent conductive layer, a dye-sensitized semiconductor layer, a porous insulating layer, and a counter electrode in order in a plurality of areas on a transparent substrate, in this case, the counter electrode being formed from a foil made of either a metal or an alloy having a catalyst layer on one surface, on a side of the porous insulating layer, or a foil made of a material having a catalytic ability, and electrically connecting the transparent conductive layer of one dye-sensitized photoelectric conversion element, and the counter electrode of the other dye-sensitized photoelectric conversion element to each other in a portion between the two dye-sensitized photoelectric conversion elements adjacent to each other; the process for impregnating at least the dye-sensitized semiconductor layer and the porous insulating layer with an electrolyte; and the process for covering the dye-sensitized photoelectric conversion elements with a sealing layer.

The order of the process for impregnating at least the dye-sensitized semiconductor layer and the porous insulating layer with the electrolyte, and the process for covering the each dye-sensitized photoelectric conversion elements with the sealing layer is no object, and thus any of these processes may be carried out.
In the second invention, with regard to any of the matters other than the foregoing, the matter described in connection with the first invention is established unless it departs from the nature thereof.

According to the third invention, there is provided an electronic apparatus having a dye-sensitized photoelectric conversion element module, the electronic apparatus being **characterized in that**:
the dye-sensitized photoelectric conversion element module has transparent conductive layers in a plurality of areas, respectively, on a transparent substrate;
the dye-sensitized photoelectric conversion element is structured by laminating a dye-sensitized semiconductor layer, a porous insulating layer, and a counter electrode in order on the transparent conductive layer;
the counter electrode is formed from a foil made of either a metal or an alloy having a catalyst layer on one surface, on a side of the porous insulating layer, or a foil made of a material having a catalytic ability;
the transparent conductive layer of one dye-sensitized photoelectric conversion element, and the counter electrode of the other dye-sensitized photoelectric conversion element are electrically connected to each other in a portion between the two dye-sensitized photoelectric conversion element adjacent to each other;
at least the dye-sensitized semiconductor layer and the porous insulating layer are impregnating with an electrolyte; and
each of the dye-sensitized photoelectric conversion elements is covered with a sealing layer.

The electronic apparatus may be basically any type one, and thus includes portable type one and stationary type one. Giving concrete examples, there are a mobile phone, a mobile device, a robot, a personal computer, an on-board apparatus, various kinds of home electric appliances, and the like. In this case, the dye-sensitized photoelectric conversion element module, for example, is a dye-sensitized solar cell used as a power source of any of these electronic apparatuses.
In the third invention, with regard to any of the matters other than the foregoing, the matter described in connection with the first invention is established unless it departs from the nature thereof.

According to the present invention constituted as described above, since only one sheet of substrate is required to be used, and the counter electrode is formed from the foil made of either the metal or the alloy having the catalyst layer thereon or the foil made of the material having the catalytic ability, the counter electrode can be structured so as to be thin, which results in that the thinning and the weight saving of the dye-sensitized photoelectric conversion element module are possible. In addition, the material for the foil made of either the metal or the alloy, and the material for the foil having the catalytic ability which compose the counter electrode are wide in the range of selection, and thus there is no restriction to a phase of the material for the counter electrode. Moreover, since the dye-sensitized semiconductor layer, and the counter electrode are separated from each other through the porous insulating layer, the dye of the dye-sensitized semiconductor layer can be prevented from being adsorbed on the counter electrode, and thus no deterioration of the characteristics is caused.

According to the present invention, it is possible to realize the dye-sensitized photoelectric conversion element module for which the thinning and the weight saving are possible, in which there is no restriction to the phase of the material for the counter electrode, and which has the same performance of the electric power generation as that of the dye-sensitized solar cell module having the Z type structure. Also, it is possible to realize the high-performance electronic apparatus by using the excellent dye-sensitized photoelectric conversion element module.

### Brief Description of Drawings

[FIG. 1]

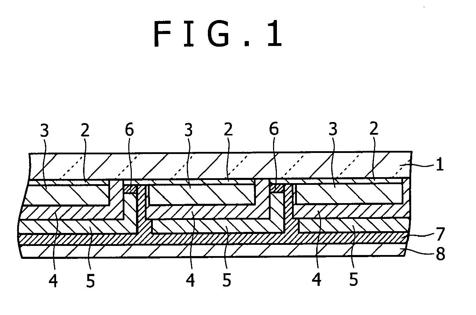

FIG. 1 is a cross sectional view of a main portion of a dye-sensitized photoelectric conversion element module according to a first embodiment of the present invention.
[FIG. 2A]

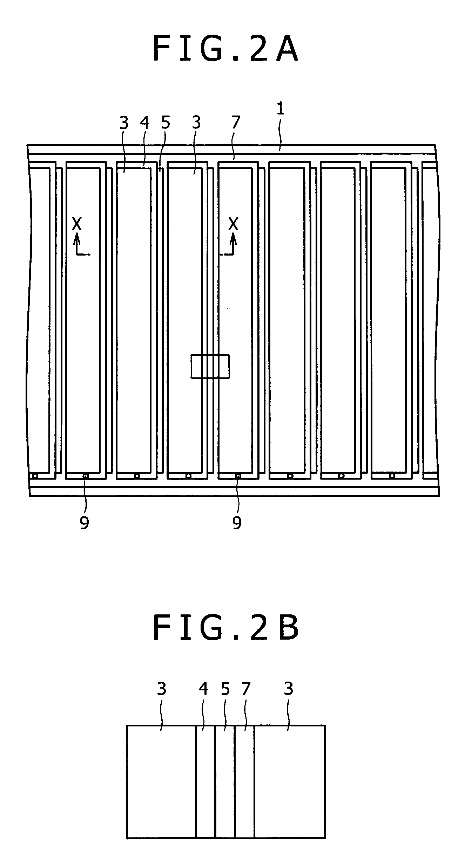

FIG. 2A is a top plan view of the main portion of the dye-sensitized photoelectric conversion element module according to the first embodiment of the present invention.
[FIG. 2B]
FIG. 2B is a top plan view of the main portion of the dye-sensitized photoelectric conversion element module according to the first embodiment of the present invention (part 1).
[FIG. 3A]

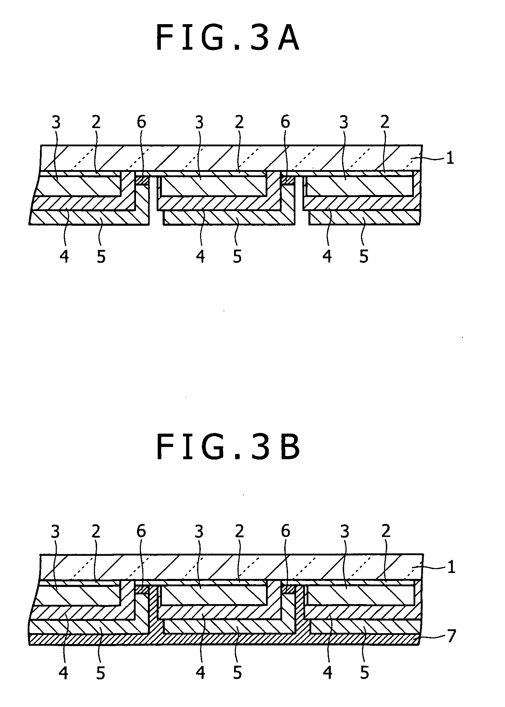

FIG. 3A is a cross sectional view for explaining a method of manufacturing the dye-sensitized photoelectric conversion element module according to the first embodiment of the present invention (part 1).
[FIG. 3B]
FIG. 3B is a cross sectional view for explaining a method of manufacturing the dye-sensitized photoelectric conversion element module according to the first embodiment of the present invention (part 2).

### Best Mode for Carrying Out the Invention

Hereinafter, embodiments of the present invention will be described with reference to the drawings.
FIG. 1, FIG. 2A and FIG. 2B each show a dye-sensitized photoelectric conversion element module according to a first embodiment of the present invention, and FIG. 1 is a cross sectional view of a main portion, and FIG. 2A is a top plan view thereof. FIG. 1 corresponds to an enlarged cross sectional view taken on line X-X of FIG. 2A.
As shown in FIG. 1 and FIG. 2A, in this dye-sensitized photoelectric conversion element module, a plurality of stripe-shaped transparent conductive layers 2 are provided on an insulating transparent substrate 1 in parallel with one another. A stripe-shaped dye-sensitized semiconductor layer 3, a stripe-shaped porous insulating layer 4 and a stripe-shaped counter electrode 5 which extend in the same direction as that of each of the transparent conductive layers 2 are laminated in order on each of the transparent conductive layers 2, thereby structuring each of dye-sensitized photoelectric conversion elements. At least the dye-sensitized semiconductor layer 3 and the porous insulating layer 4 are entirely impregnated with an electrolyte. The counter electrode 5 is formed from a foil made of either a metal or an alloy containing therein at least one or more kinds of elements selected from the group consisting of Ti, Ni, Cr, Fe, Nb, Ta, W, Co and Zr, provided with a catalyst layer containing therein at least one or more kinds of elements selected from the group consisting of Pt, Ru, Ir and C on one surface, on a side of the porous insulating layer 4, or from a foil made of a material containing therein at least one or more kinds of elements selected from the group consisting of Pt, Ru, Ir and C. In this case, a width of the dye-sensitized semiconductor layer 3 is smaller than that of the transparent conductive layer 2, and a portion thereof adjacent to one side in a longitudinal direction of the transparent conductive layer 2 is exposed. A width of the porous insulating layer 4 is larger than that of the dye-sensitized semiconductor layer 3, and the porous insulating layer 4 is provided so as to cover the entire dye-sensitized semiconductor layer 3. One end of the porous insulating layer 4 extends along one side surface of the dye-sensitized semiconductor layer 3 to contact the transparent substrate 1, and the other end thereof extends along the other side surface of the dye-sensitized semiconductor layer 3 to contact the transparent conductive layer 2. In addition, one end of the counter electrode 5 of one dye-sensitized photoelectric conversion element is joined to the transparent conductive layer 2 of the adjacent dye-sensitized photoelectric conversion element through a conductive material 6. As a result, a plurality of dye-sensitized photoelectric conversion elements are electrically connected in series with one another. The number of dye-sensitized photoelectric conversion elements connected in series with one another is selected as may be necessary. A sealing layer 7 is provided so as to cover a portion defined by the counter electrode 5 and the porous insulating layer 4 between each two dye-sensitized photoelectric conversion elements, and an entire surface of the counter electrode 5. Each of the dye-sensitized photoelectric conversion elements is sealed with the sealing layer 7. Moreover, an armoring film (armoring material) made of a gas barrier material is bonded to the entire surface of the sealing layer 7. A top plan view obtained by enlarging a portion (a portion surrounded by a chain line in FIG. 2A) of the porous insulating layer 4, the counter electrode 5 and the sealing layer 7 is shown in FIG. 2B.

A semiconductor fine particle layer obtained by supporting a dye in is used as the dye-sensitized semiconductor layer 3. A resin, a glass fit or the like, for example, is used as the sealing layer 7. A film which is equal to or smaller than 100 (cc/m²/day/atm) in permeation rate of oxygen, and is equal to or smaller than 100 (g/m²/day) in permeation rate of water vapor is suitably used as the armoring film 8.
Materials which are selected from these previously given as may be necessary can be used for the transparent substrate 1, the transparent conductive layer 2, the dye-sensitized semiconductor layer 3, and the porous insulating layer 4, and the counter electrode, respectively.

Next, a description will be given with respect to a method of manufacturing the dye-sensitized photoelectric conversion element module.
Firstly, as shown in FIG. 3A, after the transparent substrate 1 is prepared, and the transparent conductive layer 2 is formed over the entire surface of the transparent substrate 1, the transparent conductive layer 2 is patterned into stripe shapes by etching. Next, a paste into which the semiconductor fine particles are dispersed is applied at a predetermined gap onto each of the transparent conductive layers 2. Next, the transparent substrate 1 is heated at a predetermined temperature to sinter the semiconductor fine particles, thereby forming a semiconductor layer made of the semiconductor fine particle sintered body. Next, the transparent substrate 1 on which the semiconductor layer made of the semiconductor fine particle sintered body is formed, for example, is immersed in a dye solution, thereby supporting a dye for sensitizing in the semiconductor fine particles. In such a manner, the dye-sensitized semiconductor layer 3 is formed on each of the transparent conductive layers 2. Next, after the porous insulating layer 4 is formed over the entire surface, the porous insulating layer 4 is patterned into stripe shapes by etching. Next, after the conductive material 6 is formed on a joining portion to the conductor electrode 5 on each of the transparent conductive layers 2, the counter electrode 5 having the catalyst layer on one surface of the foil made of either the metal or the alloy having the predetermined shape, or the counter electrode 5 formed from the foil made of the material having the catalytic ability, is formed and is then joined to the conductive material 6.

Next, as shown in FIG. 3B, the sealing layer 7 is formed over the portion defined by the counter electrode 5 and the porous insulating layer 4 between each two dye-sensitized photoelectric conversion elements, and the entire surface of the counter electrode 5 except for a portion in which a liquid injection hole (indicated by reference numeral 8 in FIG. 2A) for each dye-sensitized photoelectric conversion element is formed.
Next, an electrolytic solution is injected through the liquid injection hole 9 previously formed every dye-sensitized photoelectric conversion element, thereby impregnating entirely each of the dye-sensitized semiconductor layer 3 and the porous insulating layer 4 with the electrolyte.
Next, the armoring film 8 is bonded to the entire surface of the sealing layer 7.
The dye-sensitized photoelectric conversion element module shown in FIG. 1 and FIG. 2A is manufactured in the manner as described above.

Next, a description will be given with respect to an operation of the dye-sensitized photoelectric conversion element module.
A light which is transmitted through the transparent substrate 1 to be made incident from the transparent substrate 1 side excites the dye of the dye-sensitized semiconductor layer 3 to generate an electron. The electron is quickly delivered from the dye to the semiconductor fine particles of the dye-sensitized semiconductor layer 3. On the other hand, the dye which has lost the electron receives an electron from an ion in the electrolyte with which each of the dye-sensitized semiconductor layer 3 and the porous insulating layer 4 are entirely impregnated, and a molecule which has delivered the electron receives an electron again on the surface of the counter electrode 5. An electromotive force is generated between the transparent conductive layer 2 electrically connected to the dye-sensitized semiconductor layer 3, and the counter electrode 5 in accordance with the series of reactions. The photoelectric conversion is carried out in the manner as described above. In this case, a total electromotive force of the electromotive forces of each dye-sensitized photoelectric conversion elements is generated between the transparent conductive layer 2 of the dye-sensitized photoelectric conversion element in one end of a plurality of dye-sensitized photoelectric conversion elements connected in series with one another, and the counter electrode 5 of the dye-sensitized photoelectric conversion element in the other end thereof.

According to the first embodiment, the counter electrode 5 can be structured to be thin because only the transparent substrate 1 is required to be used as the substrate, and the counter electrode 5 is formed from the foil made of either the metal or the alloy having the catalyst layer thereon, or the foil made of the material having the catalytic ability. As a result, the thinning and the weight saving of the dye-sensitized photoelectric conversion electrode module are possible. In addition, the material for the foil made of either the metal or the alloy having the catalyst layer thereon or the material for the foil having the catalytic ability which compose the counter electrode 5 are wide in the range of selection, and thus there is no restriction to the phase of the material for the counter electrode. Moreover, since the dye-sensitized semiconductor layer 3 and the counter electrode 5 are separated from each other through the porous insulating layer 4, the dye of the dye-sensitized semiconductor layer 3 can be prevented from being adsorbed on the counter electrode 5, and thus no deterioration of the characteristics is caused. Therefore, it is possible to realize the dye-sensitized photoelectric conversion element module which has the same performance of the electric power generation as that of the dye-sensitized solar cell module having the Z type structure. In addition thereto, each of the dye-sensitized photoelectric conversion elements is sealed with the sealing layer 7, and the armoring film 8 made of the gas barrier material is bonded to the entire surface of the sealing layer 7. Therefore, gas such as oxygen, or water vapor can be prevented from penetrating from the outside into the inside of the module. Therefore, it is possible to suppress deterioration of the characteristics such as the photoelectric conversion efficiency. For this reason, it is possible to realize the dye-sensitized photoelectric conversion element module which can maintain the excellent characteristics for a long period of time, and which has the high durability.

A description will now be given with respect to Examples of the dye-sensitized photoelectric conversion element module.
Example 1
After an FTO film was formed on a glass substrate, the FTO film was patterned by etching to eight stripe-shaped patterns so as to define a gap, having a width of 0.5 mm, between each two stripe-shaped patterns. After that, ultrasonic cleaning was carried out by using acetone, alcohol, an alkali system cleaning liquid, and ultrapure water in order, and drying was sufficiently carried out.
A titanium oxide paste made by Solaronix was applied onto the glass substrate so as to obtain eight-shaped patterns (a total area was 16 cm²) each having a width of 5 mm, and a length of 40 mm by using a screen printer. With regard to the paste, a transparent Ti-Nanoxide TSP paste, and a Ti-Nanoxide DSP containing therein scattering particles were laminated in order from the glass substrate side so as to have a thickness of 7 µm, and a thickness of 13 µm, respectively. As a result, a porous TiO₂ film having a thickness of 20 µm in total was obtained. After the porous TiO₂ film was burnt in an electrical furnace at 500°C for 30 minutes, and the standing to cool was then carried out, the porous TiO₂ film was immersed in 0.1 mol/L of a TiCl₄ solution, was held at 70°C for 30 minutes, and was sufficiently cleaned by using pure water and ethanol. After drying, the porous TiO₂ film was burnt at 500°C for 30 minutes. In such a way, a TiO₂ sintered body was manufactured.

Next, a zirconia paste for screen printing which was prepared at a predetermined viscosity by using ethyl cellulose after solvent displacement to terpineol was carried out by using a commercially available zirconia dispersion liquid was applied onto the TiO₂ sintered body described above so as to have a length of 41 mm, a width of 5.5 mm, and a thickness of 10 µm. After the resulting zirconia paste film was dried, the zirconia paste film was burnt in the electrical furnace at 500°C for 30 minutes. In such a way, a porous insulating layer was formed.

Next, the TiO₂ sintered body was immersed in a tert-butylalcohol/acetonitrile mixed medium (1 : 1 in volume) of 0.5 mM cis-bis (isothiocyanate)-N, N-bis (2,2'-dipyridyl-4,4'-dicarboxylic acid)-ruthenium (II) ditetrabutyl ammonium salt (N 719 dye) at a room temperature for 48 hours, thereby supporting the dye in the TiO₂ sintered body. The TiO₂ sintered body having the dye thus supported therein was cleaned by using acetonitrile, and was then dried in a dark place. A dye-sensitized TiO₂ sintered body was manufactured in the manner as described above.

Next, an anisotropically conductive paste was applied onto the stripe-shaped dye-sensitized TiO₂ sintered body to have a width of 0.5 mm so as to be parallel with the stripe-shaped dye-sensitized TiO₂ sintered body, and was then dried.
Next, a counter electrode obtained by spray-coating one surface of a titanium foil having a thickness of 0.05 mm with an isopropyl alcohol of 0.05 mM platinic chloride, and carrying out the burning at 385°C was cut into pieces each having a size of 6 mm × 40 mm. After the surface onto which the platinic chloride was sprayed was directed toward the dye-sensitized TiO₂ sintered body side, thereby carrying out the alignment, the anisotropically conductive paste described above, and the counter electrode were joined to each other by thermocompression bonding.

A portion through which a bonding surface of the armoring film, and a power collection terminal were connected to each other, and a pattern for liquid injection having a diameter of 1 mm were left on the glass substrate described above, and an UV cure adhesive agent was applied by screen printing so as to cover all the dye-sensitized photoelectric conversion elements. After the application, when air bubbles perfectly outgassed, an ultraviolet light was radiated to the UV cure adhesive agent by using a conveyer type UV exposure system, thereby curing the UV cure adhesive agent.

0.045 g of sodium iodide (NaI), 1.11 g of 1-propyl-2.3-dimethyl imidazolium iodide, 0.11 g of iodine (I₂), and 0.081 g of 4-tert-butyl pyridine were dissolved in methoxyacetonirile, thereby preparing an electrolyte composition.
Next, after the electrolyte composition thus prepared was injected under a reduced pressure through the liquid injection hole, having the diameter of 1 mm, prepared as described above, the electrolyte composition was held under an increased pressure of 0.4 MPa for 30 minutes, so that the electrolyte was made to perfectly penetrate into each of the dye-sensitized photoelectric conversion elements. In such a way, the dye-sensitized TiO₂ sintered body and the porous insulating layer are impregnated with the electrolyte.

Next, the liquid injection hole for the electrolyte described above was sealed with the UV cure adhesive agent, and an armoring film obtained by joining a hot-melt adhesive film to a bonding surface of a commercially available aluminum laminate film was prepared. The armoring film was fusion-bonded to the outermost peripheral portion of the transparent substrate under the reduced pressure by using a heat sealer, thereby obtaining a dye-sensitized photoelectric conversion element module. In the dye-sensitized photoelectric conversion element module, eight dye-sensitized photoelectric conversion elements each having a size of 5 mm × 40 mm were connected in series with one another.

Example 2
A dye-sensitized photoelectric conversion element module was manufactured similarly to the case of Example 1 except that a counter electrode was formed into a foil shape with a carbon paste.
Example 3
A dye-sensitized photoelectric conversion element module was manufactured similarly to the case of Example 1 except that a counter electrode was formed into a foil shape with a platinum-supported carbon paste.
Example 4
A dye-sensitized photoelectric conversion element module was manufactured similarly to the case of Example 1 except that a counter electrode was formed from a platinum foil having a thickness of 0.05 mm, and no catalyst layer was provided.
Example 5
A dye-sensitized photoelectric conversion element module was manufactured similarly to the case of Example 1 except that a counter electrode was formed into a foil shape with a carbon paper having a thickness of 0.05 mm, and no catalyst layer was provided.
Example 6
A dye-sensitized photoelectric conversion element module was manufactured similarly to the case of Example 1 except that a counter electrode was formed into a foil shape with a carbon paper having a thickness of 0.05 mm, and a catalyst layer was provided by using a platinic chloride.
Example 7
A dye-sensitized photoelectric conversion element module was manufactured similarly to the case of Example 1 except that an In paste was used instead of using an anisotropically conductive paste, and a surface contacting an electrolysis solution is covered with a resin.
Example 8
A dye-sensitized photoelectric conversion element module was manufactured similarly to the case of Example 1 except that a room-temperature cure Ag paste was used instead of using an anisotropically conductive paste, and a surface contacting an electrolysis solution is covered with a resin.
Comparative Example 1
A dye-sensitized photoelectric conversion element module having a Z type structure was manufactured in such a way that an FTO substrate was used as a counter electrode, a catalyst layer was formed by spraying an IPA solution of a platinic chloride similarly to the case of Example 1, and upper and lower substrates were joined to each other by using a power collection electrodes, made of an Ag paste, having both ends each covered with a resin.

In the dye-sensitized photoelectric conversion element modules of Examples 1 to 8, and Comparative Example 1 manufactured in the manner as described above, the photoelectric conversion efficiencies under the radiation of a pseudo-solar light (AM 1.5, 100 mW/cm²) were measured, and thicknesses of maximum protrusion portions of these dye-sensitized photoelectric conversion element modules were measured with a digital vernier caliper. The results are shown in Table 1.

**[Table 1]**

| | Photoelectric conversion efficiency % | Module thickness mm |
|---|---|---|
| Example 1 | 8.2 | 1.33 |
| Example 2 | 8.1 | 1.30 |
| Example 3 | 8.4 | 1.35 |
| Example 4 | 8.2 | 1.32 |
| Example 5 | 7.8 | 1.30 |
| Example 6 | 7.9 | 1.29 |
| Example 7 | 8.2 | 1.35 |
| Example 8 | 8.2 | 1.35 |
| Comparative Example 1 | 8.3 | 2.37 |

It is understood from TABLE 1 that the dye-sensitized photoelectric conversion element modules of Examples 1 to 8 are excellent in performance of electric power generation, and are greatly thinned as compared with the case of Comparative Example 1.
Moreover, in the dye-sensitized photoelectric conversion element modules of Examples 1 to 8 manufactured in the manner as described above, the photoelectric conversion efficiencies after radiation of the pseudo-solar light (AM 1.5, 100 mW/cm²) at 60°C for 1000 hours (durability accelerated test) were measured. As a result, it was found out that these dye-sensitized photoelectric conversion element modules are very excellent in durability.

Next, a description will be given with respect to a dye-sensitized photoelectric conversion element module according to a second embodiment of the present invention.
In this dye-sensitized photoelectric conversion element module, in the dye-sensitized photoelectric conversion element module according to the first embodiment, an electrolyte is made of an electrolyte composition which contains therein iodine, and contains therein a compound having at least one isocyanate group (-NCO), more preferably in which the compound contains therein at least one or more nitrogen containing functional groups within the same molecule in addition to the isocyanate group, or which further contains therein a compound having at least one or more nitrogen containing functional groups in addition to that compound. Although there is especially no limit to the compound having at least one or more isocyanate groups (-NCO), the compound is preferably compatible with a solvent of an electrolyte, an electrolyte salt, and other addition agents. Although the compound having at least one or more nitrogen contacting functional group is suitably an amine system compound, the compound concerned is not especially limited thereto. Although there is especially no limit to the amine system compound, the amine system compound is preferably compatible with a solvent of an electrolyte, an electrolyte salt, and other addition agents. The nitrogen containing functional group is made to exist together with the compound having at least one or more isocyanate groups, which especially, largely contributes to an increase in open voltage of the dye-sensitized photoelectric conversion element modules. Specifically, the compound having at least one or more isocyanate groups, for example, is isocyanic phenyl, isocyanic 2-chloroethyl, isocyanic m-chlorophenyl, isocyanic cyclohexyl, isocyanic o-tolyl, isocyanic p-tolyl, isocyanic n-hexyl, 2,4-diisocyanic tolylene, diisocyanic hexamethylene, 4,4'-diisocyanic methylenediphenyl or the like. However, the present invention is by no means limited thereto. In addition, specifically, the amine system compound, for example, is 4-tert-butylpyridine, aniline, N,N-dimethylanilene, N-methylbenz imidazole, or the like. However, the present invention is by no means limited thereto.
Any of the matters other than the foregoing is similar to that in the dye-sensitized photoelectric conversion element module according to the first embodiment.

According to the second embodiment, in addition to the same advantage as that of the first embodiment, it is possible to obtain an advantage that the electrolyte layer 7 is made of the electrolyte compound containing therein the compound having at least one or more isocyanate groups, which results in that both the short current and the open voltage can be increased, thereby making it possible to obtain the dye-sensitized photoelectric conversion element module having the very high photoelectric conversion efficiency.

Example 9
During the preparation of the electrolyte compound in Example 1, 0.045 g of sodium iodide (NaI), 1.11 g of 1-propyl-2.3-dimethyl imidazolium iodide, 0.11 g of iodine (I₂), and 0.081 g of 4-tert-butyl pyridine was added to 3 g of propylene carbonate, and 0.071 g (0.2 mol/L) of isocyanic phenyl was dissolved therein. Any of other matters is made similar to that in Example 1, and a dye-sensitized photoelectric conversion element module was obtained.

Although the embodiments of the present invention, and Examples have been concretely described so far, the present invention is by no means limited to the embodiments and Examples described above, and thus various changes based on the technical idea of the present invention can be made.
For example, the numerical values, the structures, the shapes, the materials, the raw materials, the processes, and the like which have been given in the embodiments and Examples described above are merely an example, and thus numerical values, structures, shapes, materials, raw materials, processes and the like which are different from those given in the embodiments and Examples described above may be used as may be necessary.

## Claims

1. A dye-sensitized photoelectric conversion element module having a plurality of dye-sensitized photoelectric conversion elements electrically connected in series with one another, said dye-sensitized photoelectric conversion element module being **characterized in that**:
a plurality of areas on a transparent substrate have transparent conductive layers, respectively;
a dye-sensitized semiconductor layer, a porous insulating layer and a counter electrode are laminated in order on said transparent conductive layer, thereby structuring the dye-sensitized photoelectric conversion element;
said counter electrode is formed from a foil made of either a metal or an alloy having a catalyst layer on one surface, of said porous insulating layer, or from a foil made of a material having a catalytic ability;
said transparent conductive layer of one dye-sensitized photoelectric conversion element, and said counter electrode of the other dye-sensitized photoelectric conversion element are electrically connected to each other in a portion between the two dye-sensitized photoelectric conversion elements adjacent to each other;
at least said dye-sensitized semiconductor layer and said porous insulating layer are impregnated with an electrolyte; and
each of said dye-sensitized photoelectric conversion elements is covered with a sealing layer.

2. The dye-sensitized photosensitive conversion element module according to claim 1, **characterized in that** said foil, made of either the metal or the alloy contains therein at least one or more kinds of elements selected from the group consisting of Ti, Ni, Cr, Fe, Nb, Ta, W, Co and Zr.

3. The dye-sensitized photosensitive conversion element module according to claim 2, **characterized in that** said catalyst layer or said material having said catalytic ability contains therein at least one or more kinds of elements selected from the group consisting of Pt, Ru, Ir and C.

4. The dye-sensitized photosensitive conversion element module according to claim 3, **characterized in that** said counter electrode and said transparent conductive layer are joined to each other through a conductive adhesive agent, or a low-melting point metal having a melting point of 300°C or less, or an alloy.

5. The dye-sensitized photosensitive conversion element module according to claim 1, **characterized in that** an armoring material made of a material having a gas barrier property is provided on said sealing layer.

6. The dye-sensitized photosensitive conversion element module according to claim 5, **characterized in that** said material having the gas barrier property is equal to or smaller than 100 (cc/m²/day/atm) in permeation rate of oxygen, and is equal to or smaller than 100 (g/m²/day) in permeation rate of water vapor.

7. The dye-sensitized photosensitive conversion element module according to claim 6, **characterized in that** said armoring material is a film obtained by laminating at least one or more kinds of materials, each having the gas barrier property, selected from the group consisting of aluminum, silica and alumina.

8. A method of manufacturing a dye-sensitized photoelectric conversion element module having a plurality of dye-sensitized photoelectric conversion elements electrically connected in series with one another, said manufacturing method being **characterized by** having:
the process for structuring the dye-sensitized photoelectric conversion element by laminating a transparent conductive layer, a dye-sensitized semiconductor layer, a porous insulating layer, and a counter electrode in order in a plurality of areas on a transparent substrate, in this case, said counter electrode being formed from a foil made of either a metal or an alloy having a catalyst layer on one surface, on a side of said porous insulating layer, or from a foil made of a material having a catalytic ability, and electrically connecting said transparent conductive layer of one dye-sensitized photoelectric conversion element, and said counter electrode of the other dye-sensitized photoelectric conversion element to each other in a portion between the two dye-sensitized photoelectric conversion elements adjacent to each other;
the process for impregnating at least said dye-sensitized semiconductor layer and said porous insulating layer with an electrolyte; and
the process for covering said dye-sensitized photoelectric conversion elements with a sealing layer.

9. An electronic apparatus having a dye-sensitized photoelectric conversion element module, said electronic apparatus being **characterized in that**:
said dye-sensitized photoelectric conversion element module has transparent conductive layers in a plurality of areas, respectively, on a transparent substrate;
said dye-sensitized photoelectric conversion element is structured by laminating a dye-sensitized semiconductor layer, a porous insulating layer, and a counter electrode in order on said transparent conductive layer;
said counter electrode is formed from a foil made of either a metal or an alloy having a catalyst layer on one surface, on a side of said porous insulating layer, or from a foil made of a material having a catalytic ability;
said transparent conductive layer of one dye-sensitized photoelectric conversion element, and said counter electrode of the other dye-sensitized photoelectric conversion element are electrically connected to each other in a portion between the two dye-sensitized photoelectric conversion element adjacent to each other;
at least said dye-sensitized semiconductor layer and said porous insulating layer are each impregnating with an electrolyte; and
each of said dye-sensitized photoelectric conversion elements is covered with a sealing layer.
